(19) Europäisches Patentamt
European Patent Office
Office européen des brevets

(11) **EP 4 768 931 A1**

(12) **EUROPEAN PATENT APPLICATION**
published in accordance with Art. 153(4) EPC

(43) Date of publication:
01.07.2026 Bulletin 2026/27

(21) Application number: 25809954.8

(22) Date of filing: 18.04.2025

(51) International Patent Classification (IPC):
$G01R\ 31/36^{(2020.01)}$    $G01R\ 31/52^{(2020.01)}$
$G01R\ 31/396^{(2019.01)}$    $G01R\ 19/165^{(2006.01)}$
$G01R\ 19/10^{(2006.01)}$

(52) Cooperative Patent Classification (CPC):
G01R 19/10; G01R 19/165; G01R 31/36;
G01R 31/396; G01R 31/52

(86) International application number:
PCT/KR2025/005319

(87) International publication number:
WO 2025/234641 (13.11.2025 Gazette 2025/46)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 08.05.2024 KR 20240060784
11.06.2024 KR 20240075926

(71) Applicant: LG Energy Solution, Ltd.
Seoul 07335 (KR)

(72) Inventors:
• IN, Yongha
Daejeon 34122 (KR)
• LEE, Bomjin
Daejeon 34122 (KR)

(74) Representative: Plasseraud IP
104 Rue de Richelieu
CS92104
75080 Paris Cedex 02 (FR)

(54) **BATTERY DIAGNOSIS DEVICE AND BATTERY DIAGNOSIS METHOD THEREOF**

(57) According to an embodiment disclosed in the present document, a battery diagnosis device may include: an information acquisition interface for acquiring time-series data on a voltage of each of a plurality of battery banks included in a battery pack; and a processor, wherein the processor calculates each piece of filtering data by removing noise from the time-series data of each of the plurality of battery banks, calculates each piece of first feature data and each piece of second feature data by converting each piece of filtering data, calculates a first index value and a second index value corresponding to each of the plurality of battery banks on the basis of each piece of the first feature data and each piece of the second feature data, and diagnoses a state of each of the battery banks on the basis of at least a part of the first index value and the second index value.

**FIG. 1**

# Description

## Technical Field

This application claims the benefit of priority based on Korean Patent Application No. 2024-0060784 filed on May 8, 2024, and Korean Patent Application No. 2024-0075926 filed on June 11, 2024, the entire disclosures of which are incorporated herein by reference.

Example embodiments disclosed in this document relate to a battery diagnostic device and diagnosis method thereof.

## Background Art

In recent years, there has been active research and development in the field of secondary batteries. Here, secondary batteries refer to batteries capable of being charged and discharged, including existing Ni/Cd batteries, Ni/MH batteries, and recent lithium-ion batteries. Lithium-ion batteries of secondary batteries have an advantage of having greater energy density than Ni/Cd batteries and Ni/MH batteries. In addition, since lithium-ion batteries may be manufactured in a compact and lightweight form, lithium-ion batteries are used as a power source of a mobile device and, in recent years, their usage range has been broadened to a power source of an electric vehicle, gaining attention as a next-generation energy storage device.

An electric vehicle receives electricity from the outside to charge a battery and then obtains power by driving a motor with voltages charged in the battery. During production and usage, batteries undergo various types of charging and discharging that cause internal deformation and deterioration, leading to changes in their physicochemical properties, and thus a defect may occur, a defect where lithium ions released from a positive electrode are not reduced into a negative electrode but instead deposited on the surface of the negative electrode. When lithium deposition is repeated continuously, inner short between the negative electrode and the positive electrode of the battery may occur, and the battery in which inner short occurs may have an issue, such as an under-voltage defect in which a voltage decreases below a certain level, or an increased risk of ignition. Therefore, a method of diagnosing inner short or lithium deposition of a battery in advance is required.

## Detailed Description of the Invention

## Technical Goals

In general, battery inner short diagnosis and battery cell balancing are performed based on a voltage of each battery cell. However, when cell balancing is performed, a voltage deviation may be offset due to voltage distribution of each battery cell. In addition, since cell balancing is currently performed prior to an inner short diagnosis operation in a battery pack, inner short diagnosis may not be performed properly due to voltage uniformity temporarily restored as a result of the cell balancing operation. In addition, as the number of battery cells included in a battery bank increases, the voltage deviation of each battery cell decreases, making it more difficult to diagnose inner short.

To solve the above-mentioned issues, according to example embodiments disclosed in this document, there are provided a battery diagnosis device capable of effectively diagnosing inner short of a battery by extracting data features and indicators specialized for inner short and lithium deposition, and a battery diagnosis method thereof.

The technical tasks of example embodiments disclosed in this document are not limited to those mentioned above, and other technical tasks not explicitly mentioned will be clearly understood by those skilled in the art from the following descriptions.

## Technical solutions

According to an example embodiment disclosed in this document, a battery diagnosis device includes an information acquisition interface that acquires time-series data for a voltage of each of a plurality of battery banks included in a battery pack, and a processor. The processor may calculate a plurality of filtering data by removing noise of the time-series data of each of the plurality of battery banks, calculate first feature data and second feature data by converting each of the plurality of filtering data, calculate a first indicator value and a second indicator value corresponding to each of the plurality of battery banks based on the first feature data and the second feature data, and diagnose a state of the plurality of battery banks based on at least a portion of the first indicator value and the second indicator value.

According to an example embodiment, the processor may remove the noise of the time-series data of each of the plurality of battery banks based on a Savitzky-Golay filter.

According to an example embodiment, the processor may calculate the first feature data including a plurality of normalized data calculated by grouping each of the plurality of filtering data in frame units of a predetermined size while moving each of the plurality of filtering data in sliding units.

According to an example embodiment, the processor may calculate the second feature data based on a coefficient value calculated by inputting the first feature data into a linear regression model.

According to an example embodiment, the processor may calculate deviations of each of the plurality of normalized data for the first feature data and calculate an average of the deviations as a second indicator value.

According to an example embodiment, the processor may calculate the first indicator value based on a factor extracted by inputting at least a portion of the first feature data and the second feature data into a decomposition model.

According to an example embodiment, the decomposition model may include a singular value decomposition model, and the processor may calculate the first indicator value based on a transposed matrix factor extracted from the singular value decomposition model.

According to an example embodiment, the processor may calculate a reconstruction matrix based on factors extracted by applying the decomposition model, normalize the reconstruction matrix, and determine whether the first indicator value is noise based on a gradient of the reconstruction matrix calculated by multiplying a coefficient value, which is extracted by inputting the normalized reconstruction matrix into the linear regression model, by a magnitude of the reconstruction matrix.

According to an example embodiment, the processor may diagnose the state of the plurality of battery banks based on whether the first indicator value is greater than a first threshold value and whether the second indicator value is greater than a second threshold value.

According to an example embodiment disclosed in this document, a battery diagnosis method may include acquiring time-series data for a voltage of each of a plurality of battery banks included in a battery pack, calculating a plurality of filtering data by removing noise of the time-series data of each of the plurality of battery banks, calculating first feature data and second feature data by converting each of the plurality of filtering data, calculating a first indicator value and a second indicator value corresponding to each of the plurality of battery banks based on the first feature data and the second feature data, and diagnosing a state of the plurality of battery banks based on at least a portion of the first indicator value and the second indicator value.

**Effects of the Invention**

A battery diagnosis device and a battery diagnosis method thereof according to example embodiments disclosed in this document may reduce an incorrect diagnosis rate of battery diagnosis and improve diagnostic sensitivity by extracting features and indicators specialized for battery bank diagnosis. Accordingly, it is possible to prevent a breakdown of a battery pack and accidents caused by inner short.

In addition, various effects that are directly or indirectly identified through the present disclosure may be provided.

**Brief Description of Drawings**

FIG. 1 is a block diagram showing a configuration of a battery diagnosis device according to an example embodiment disclosed in this document.

FIG. 2 is a diagram showing an example of removing noise according to an example embodiment disclosed in this document.

FIG. 3 is a diagram showing an example of calculating first feature data according to an example embodiment disclosed in this document.

FIG. 4 is a diagram showing an example of calculating a first indicator value according to an example embodiment disclosed in this document.

FIG. 5 is a diagram showing an example of determining whether a first indicator value is noise according to an example embodiment disclosed in this document.

FIG. 6 is a diagram showing an example of diagnosing a battery bank based on a first indicator value and a second indicator value according to an example embodiment disclosed in this document.

FIG. 7 is a flowchart for describing a diagnosis method of a battery diagnosis device according to an example embodiment disclosed in this document.

FIG. 8 is a block diagram showing a hardware configuration of a computing system for performing an operation method of a battery diagnosis device according to an example embodiment disclosed in this document.

**Mode for Carrying Out the Invention**

The following description of various example embodiments disclosed in this document is provided with reference to the accompanying drawings. However, this is not intended to limit the present disclosure to any specific example embodiment, and it is to be understood that various modifications, equivalents, and/or alternatives of example embodiments of the present disclosure are included within the scope of the present disclosure.

In this document, singular forms of nouns corresponding to items may include both singular and plural forms unless the context clearly indicates otherwise. In this document, expressions such as "A or B," "at least one of A and B," "at least one of A or B," "A, B, or C," "at least one of A, B, and C," and "at least one of A, B, or C" are intended to include any one of the listed items or any combination of two or more of the listed items. Terms such as "first," "second," "primary," or "secondary" may be used merely to differentiate one element from another element and are not intended to limit the elements by importance, order, or any other attribute. When a certain (for example, first) element is said to be "coupled" or "connected" to another (for example, second) element, with or without terms such as "functionally" or "communicatively," it means that the certain element may be connected to the other element directly (for example, via a wired connection), wirelessly, or through a third element.

Each of the elements (for example, modules or programs) described in the present disclosure may include a single entity or a plurality of entities. According to various example embodiments, one or more of the elements or operations may be omitted, or one or more other elements or operations may be added. Alternatively or additionally, a plurality of elements (for example, modules or programs) may be integrated into a single element. In such a case, the integrated element may be capable of performing one or more functions of each of the plurality of elements in the same or similar manner as performed by the corresponding elements among the plurality of elements before the integration. According to various example embodiments, operations performed by a module, a program, or other elements may be executed sequentially, in parallel, repeatedly, or heuristically, and one or more of the operations may be executed in a different order, omitted, or supplemented with one or more additional operations.

In this document, the terms "module" or "...part" may include a unit implemented in hardware, software, or firmware, and may be used interchangeably with terms such as logic, a logic block, a part, or a circuit. A module may be an integrated part, or a minimum unit or a portion thereof, which performs one or more functions. For example, according to an example embodiment, a module may be implemented in an application-specific integrated circuit (ASIC) form.

Various example embodiments of the present document may be implemented as software (for example, a program or an application) that includes one or more instructions stored in a machine-readable storage medium (for example, a memory). For example, a processor of a device may call and execute at least one instruction among the one or more instructions stored in the storage medium. This enables the device to be operated to perform at least one function according to the at least one instruction called. The one or more instructions may include a code generated by a compiler or a code that may be executed by an interpreter. The machine-readable storage medium may be provided in a non-transitory storage medium form. Here, 'non-transitory' merely means that the storage medium is a tangible device and does not include a signal (for example, an electromagnetic wave), and the term does not distinguish between a case where data are stored semi-permanently in the storage medium and a case where data are stored temporarily.

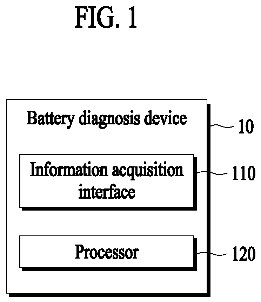

FIG. 1 is a block diagram showing a configuration of a battery diagnosis device according to an example embodiment disclosed in this document.

Referring to FIG. 1, a battery diagnosis device 10 may include an information acquisition interface 110 and a processor 120.

The battery diagnosis device 10 may diagnose a state of each of a plurality of battery banks included in a battery pack. In the battery pack, the plurality of battery banks may be arranged in series and/or in parallel, and each of the battery banks may include a plurality of battery cells.

By using time-series data for voltages of the plurality of battery banks, the battery diagnosis device 10 may diagnose, among the plurality of battery banks, a battery bank that includes a battery cell in which an open circuit occurs in an electrode tab or a battery cell in which the open circuit of the electrode tab and lithium deposition occur simultaneously. Here, lithium deposition refers to a phenomenon where a lithium ion that comes from a positive electrode during charging of a battery cell fails to be chemically bonded to a negative electrode, but exists in a metallic form on a surface of the negative electrode. In a case of a normal battery cell, a lithium ion from a positive electrode of the battery cell is reduced within a negative electrode during charging. However, in a case of a defective battery cell, partial lithium ions may be deposited in a lithium metallic form on a surface of a negative electrode. When the lithium deposition phenomenon is repeated and lithium byproducts grow, the lithium byproducts may come into contact with a positive electrode or a positive electrode collector, so that inner short between the negative electrode and the positive electrode of the battery cell may occur. In the battery bank in which inner short occurs, a voltage deviation from the normal battery bank may occur over time due to self-discharge.

In addition, an open circuit may occur in a positive electrode tab or a negative electrode tab of the battery cell due to a variety of causes, such as a defect generated during a production process, inner deformation caused by a plurality of times of charging and discharging, or external shocks. When the lithium deposition phenomenon and the open circuit in the electrode tab occur simultaneously in the battery cell, an electrode of the battery cell with the open circuit may be connected to an electrode of the normal battery cell through lithium deposits. Here, when a negative electrode of the battery cell with the open circuit has a higher state of charge (SOC) than that of the negative electrode of the normal battery, the negative electrodes of the two battery cells may come into contact with each other through the lithium deposits, so that charging from the negative electrode of the battery cell with the open circuit to the negative electrode of the normal battery may occur. Therefore, when compared to the normal battery cell, a greater and faster voltage change may occur in the battery cell in which the lithium deposition phenomenon and the open circuit in the electrode tab occur simultaneously.

Accordingly, the battery diagnosis device 10 may diagnose the state of the battery bank by extracting features and indicators specialized for diagnosing the state of the plurality of battery banks.

In addition, an operation of the battery diagnosis device 10 may be performed by a battery management system (BMS) or various devices, such as a server, cloud, a charger, and a charge/discharge device, connected to a vehicle equipped with the BMS.

The information acquisition interface 110 may acquire time-series data for a voltage of each of the plurality of battery banks in the battery pack. For example, the information acquisition interface 110 may acquire a voltage value of each battery bank at a specific time interval and acquire time-series data for the voltage value. In other words, the time-series data may be a set of voltage values acquired at a plurality of points in time. The information acquisition interface 110 may further acquire data other than voltages, such as a current, temperature, and state-of-charge (SOC) of the battery pack.

When the battery diagnosis device 10 is a BMS of the battery pack, the information acquisition interface 110 may be an element, for example, a voltage sensor, that directly measures a voltage of the battery pack. In addition, when the battery diagnosis device 10 is a vehicle BMS, a server, cloud, or a charge/discharge device, the information acquisition interface 110 may be a communication interface that receives voltage information measured from an element that measures a voltage of the battery pack (for example, a voltage sensor of a battery pack).

The processor 120 may diagnose the state of each battery bank by analyzing the time-series data acquired from the information acquisition interface 110. Unless otherwise specified, the processor 120 in the present disclosure may refer to a set of one or more processors 120.

According to an example embodiment, the processor 120 may calculate a plurality of filtering data by removing noise of the time-series data of the plurality of battery banks. Since noise data may cause distortion in a data analysis process, the processor 120 may calculate the filtering data by removing the noise included in the time-series data. Here, removing the noise by the processor 120 may include correcting each voltage value included in the time-series data. The processor 120 may calculate the filtering data for each of the plurality of battery banks.

For example, when time-series data of an $i^{th}$ battery bank is represented as $(v_i^1, v_i^2, \cdots v_i^n)$, filtering data may be represented as $(f_i^1, f_i^2, \cdots f_i^n)$ in which each voltage value is corrected. Here, n is a natural number and denotes the number of points in time at which the voltage value is acquired by the information acquisition interface 110, and i may be an arbitrary natural number less than or equal to the number of battery banks included in the battery pack.

According to an example embodiment, the processor 120 may remove the noise of the time-series data of the plurality of battery banks based on a Savitzky-Golay filter. The Savitzky-Golay filter, as a type of filter for data smoothing, may enhance data precision without distorting a data trend.

For example, in the Savitzky-Golay filter, parameters such as a window length and a polyorder for data smoothing may be set. The window length may refer to a unit length for data smoothing, and the polyorder may refer to a polynominal degree applied in data smoothing.

For example, the Savitzky-Golay filter may smooth input data through a process of replacing each datum with a combination of data values included in the window length centered on each datum.

Applying the Savitzky-Golay filter in the processor 120 to remove the noise of the time-series data is merely an example. In addition to the Savitzky-Golay filter, various types of filters such as a moving average filter, an exponential smoothing filter, and the like may be applied.

According to an example embodiment disclosed in this document, the processor 120 may calculate first feature data and second feature data by converting each of the plurality of filtering data. Here, the first feature data and the second feature data may correspond to each of the plurality of battery banks.

For enhancing accuracy and sensitivity of battery state diagnosis, the processor 120 may perform diagnosis of the battery bank by using diagnosis-specialized feature data depending on a diagnosis purpose. For example, for diagnosing inner short of the battery pack, the processor 120 may calculate the first feature data and second feature data specialized for inner short diagnosis and use the first feature data and the second feature data for diagnosis.

According to an example embodiment, the processor 120 may calculate the first feature data including a plurality of normalized data calculated by grouping each of the plurality of filtering data in frame units of a predetermined size while moving each of the plurality of filtering data in sliding units. For example, for the filtering data, the processor 120 may apply a moving window moving in sliding units to calculate the plurality of normalized data from each of the filtering data and calculate the first feature data including the plurality of calculated normalized data. Here, the sliding units, as a criterion for moving the moving window, may refer to a time interval at which the normalized data are calculated. In addition, the frame units may refer to the number of voltage values included in one normalized datum. The frame units may be "2" or greater. In other words, the processor 120 may calculate the first feature data corresponding to each of the filtering data by converting each of the filtering data.

The processor 120 may group voltage values corresponding to frame units to include, at each point in time at which normalized data are calculated, the voltage value corresponding to each point in time. The processor 120 may calculate normalized data by grouping voltage values for points in time before and after each point in time at which the normalized data are calculated.

For example, when the filtering data of the $i^{th}$ battery bank is $(f_i^1, f_i^2, \cdots f_i^n)$, when the processor 120 calculates second normalized data on the basis of a fourth point in time after calculating first normalized data on the basis of a first point in time, a sliding unit may be "3". In addition, when the processor 120 calculates the first normalized data as $G_i^1 = (f_i^1, f_i^2, f_i^3, f_i^4)$, a frame unit

may be "4". In other words, each of the normalized data may have an equal size and be understood as a voltage profile including a plurality of filtered voltage values.

As such, the processor 120 may calculate the first feature data, each of which includes the plurality of normalized data. For example, the first feature data for the i$^{th}$ battery bank may be represented as ($G_i^1$, $G_i^2$, $\cdots$, $G_i^m$). Here, m is the number of the normalized data, and may be less than n, which is the number of points in time at which the voltage value is acquired. The number of the normalized data may change according to the sliding unit and the frame unit.

According to an example embodiment, the processor 120 may calculate the second feature data based on a coefficient value calculated by inputting the first feature data into a linear regression model. The linear regression model may refer to a model for analyzing a relationship between input data and output data. Here, the second feature data may refer to gradients of the normalized data included in the first feature data.

In other words, the processor 120 may analyze a voltage change (e.g., gradient) on the voltage profile represented by each of the normalized data by inputting the first feature data into the linear regression model and calculate the second feature data based on the coefficient value of the linear regression model acquired as a result of the analysis.

For example, when the first feature data for the i$^{th}$ battery bank is ($G_i^1$, $G_i^2$, $\cdots$, $G_i^m$), the processor 120 may calculate a gradient of each of the normalized data. When the gradient of each of the normalized data is $s_i^j$, the second feature data of the i$^{th}$ battery bank may be represented as ($s_i^1$, $s_i^2$, $\cdots$, $s_i^m$). Here, j is an arbitrary natural number equal to or greater than 1 and less than or equal to m.

According to an example embodiment, the processor 120 may calculate a first indicator value and a second indicator value corresponding to each of the plurality of battery banks based on the first feature data and the second feature data. The first indicator value and the second indicator value may be reference values for diagnosing the state of each battery bank.

According to an example embodiment, the processor 120 may calculate the first indicator value by inputting at least a portion of each of the first feature data and each of the second feature data into a decomposition model. For example, the processor 120 may organize the first feature data of each battery bank into a k*m matrix to be input into the decomposition model. Here, k denotes the number of battery banks included in the battery pack.

The decomposition model may refer to a model for facilitating data analysis by decomposing input data into factors composing the input data. For example, the decomposition model may decompose the input data into a plurality of matrix factors. As an example, the decomposition model may decompose input data I into a plurality of matrix factors A, B, and C that satisfy I = A * B * C.

According to an example embodiment, the decomposition model may include a singular value decomposition model (SVD). The SVD model may decompose input data into an orthogonal matrix and a diagonal matrix.

For example, the SVD model may decompose input data (matrix) into orthogonal matrix U, $V^T$, and diagonal matrix $\Sigma$ representing a singular value of the input data. Here, when a size of the input data is k * m, U may be an orthogonal matrix of k * k size, $V^T$ may be an orthogonal matrix of m * m size, and the singular value matrix $\Sigma$ may be a diagonal matrix of k * m size.

According to an example embodiment, the processor 120 may calculate the first indicator value based on a transposed matrix factor extracted from the SVD model. Here, the transposed matrix factor may be the orthogonal matrix $V^T$. For example, the processor 120 may calculate an absolute value of the transposed matrix $V^T$ as the first indicator value. As an example, the processor 120 may represent non-zero components of the transposed matrix $V^T$ as a one-dimensional vector and calculate an absolute value of the one-dimensional vector as the first indicator value.

According to an example embodiment, the processor 120 may calculate a reconstruction matrix based on factors extracted by applying the decomposition model. For example, the processor 120 may extract a portion of each factor of input data and calculate the reconstruction matrix based on a multiplication operation of the extracted factors. The reconstruction matrix calculated in this way may take a form of a one-dimensional matrix. As an example, for each of U, $V^T$, and $\Sigma$ factors, which are extracted by inputting the input data into the SVD model, the processor 120 may calculate the reconstruction matrix by performing the multiplication operation on a portion of each factor.

For example, the processor 120 may adjust an index of the SVD model and decompose the input data so that each factor has a plurality of data values according to a data trend. For example, when a size of the input data is k * m, the processor 120 may represent a U matrix as a three-dimensional matrix of size k * l * p, represent $V^T$ matrix as a three-dimensional matrix of size m * l * p, and represent $\Sigma$ matrix as a one-dimensional vector of size m for a singular value. Here, m denotes the number of battery banks, l denotes the number of normalized data of each battery bank, k denotes a size of the frame unit, and p denotes the number that distinguishes between factors according to the trend.

Here, the processor 120 may calculate the reconstruction matrix by extracting a second trend except for components corresponding to a first trend p for the matrix U and the matrix $V^T$. For example, the processor 120 may extract a two-dimensional matrix corresponding to second columns of z columns (in other words, columns separated by a trend) of the U matrix and the $V^T$ matrix, and calculate the reconstruction matrix by performing the multiplication operation of the above matrices and the $\Sigma$ matrix.

Thereafter, the processor 120 may normalize the reconstruction matrix. For example, the processor 120 may perform min-max normalization for the reconstruction matrix. The min-max normalization may refer to a transformation of all values in the reconstruction matrix to fall within a specified minimum value and a maximum value.

The processor 120 may determine whether the first indicator value is noise based on a gradient of the reconstruction matrix calculated by multiplying a coefficient value, which is extracted by inputting the normalized reconstruction matrix into the linear regression model, by a magnitude of the reconstruction matrix.

According to an example embodiment, the processor 120 may determine whether the gradient of the reconstruction matrix is greater than a reference value. When the gradient of the reconstruction matrix is equal to or less than the reference value, the processor 120 may determine that the first indicator value is noise. Conversely, when the gradient of the reconstruction matrix is greater than the reference value, the processor 120 may use the first indicator value for diagnosis. The reference value may be set to, for example, "0.6."

When the first indicator value is determined as noise, the processor 120 may not use the first indicator value for diagnosis. In other words, the first indicator value determined as noise may be excluded from a diagnosis process.

According to an example embodiment, the processor 120 may perform noise determination only when the first indicator value is greater than or equal to a specific value. As will be described later, since the processor 120 diagnoses an abnormality of the battery bank by comparing the first indicator value and a first threshold value, the processor 120 may determine whether the first indicator value is noise when the first indicator value is equal to or greater than a specific value. For example, the specific value may be equal to the first threshold value. Through this, the processor 120 may prevent over-diagnosis of the battery bank caused by noise.

According to an example embodiment, the processor 120 may calculate deviations of the plurality of normalized data for the first feature data and calculate an average of the deviations as a second indicator value. The processor 120 may calculate the second indicator value corresponding to each of the plurality of battery banks.

For example, when the first feature data of the $i^{th}$ battery bank is $(G_i^1, G_i^2, \cdots, G_i^m)$, the processor 120 may calculate an average of each of the normalized data. For example, the processor 120 may calculate an average of first normalized data of a first battery bank to a $k^{th}$ battery bank as $\mathrm{median} = \dfrac{G_1^1 + G_2^1 + \cdots G_k^1}{k}$ and calculate a deviation ($|G_i^j$-median$|$) from the average of the first normalized data of each battery bank. Here, K denotes the number of battery banks included in the battery pack.

Thereafter, the processor 120 may calculate the average of each deviation of the plurality of normalized data included in the $i^{th}$ battery bank as the second indicator value for the $i^{th}$ battery bank.

According to an example embodiment, the processor 120 may diagnose the state of the plurality of battery banks based on at least a portion of the first indicator value and the second indicator value. In other words, the first indicator value and the second indicator value may be reference values for diagnosing the state of the battery bank. The processor 120 may diagnose the state of each of the plurality of battery banks based on at least a portion of the first indicator value and the second indicator value.

According to an example embodiment disclosed in this document, the processor 120 may diagnose the state of the plurality of battery banks based on whether the first indicator value is greater than the first threshold value and whether the second indicator value is greater than a second threshold value. For example, the processor 120 may diagnose the battery bank as abnormal when the first indicator value is greater than the first threshold and the second indicator value is greater than the second threshold.

According to an example embodiment, diagnosing the state of the battery bank by the battery diagnosis device 10 may include diagnosing the battery bank as a battery bank in which an open circuit occurs in an electrode tab or a battery bank in which the open circuit in the electrode tab and lithium deposition occur.

When the processor 120 diagnoses the first battery bank as the battery bank in which the open circuit occurs in the electrode tab or the battery bank in which the open circuit in the electrode tab and lithium deposition occur, the processor 120 may track and monitor whether inner short occurs in the first battery bank.

Furthermore, when it is determined that the battery bank is abnormal as a result of the diagnosis, the processor 120 may provide a user with information on the abnormal battery bank. As an example, a controller 120 may provide a user terminal with information on an abnormal battery bank through a communication part (not illustrated) and also provide the information on the abnormal battery bank through a display provided in a vehicle or a charger.

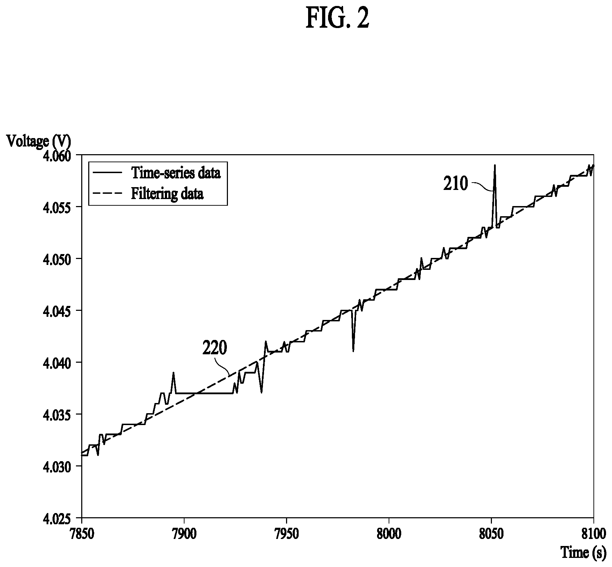

FIG. 2 is a diagram showing an example of removing noise according to an example embodiment disclosed in this document. In FIG. 2, an x-axis represents a time index (s), and a y-axis represents a voltage value (v).

In FIG. 2, a graph 210 represents voltage time-series data of a first battery bank acquired from an information acquisition interface 110, and a graph 220 represents filtering data calculated by removing noise of time-series data. For example, the processor 120 may calculate the filtering data 220 by removing noise of the time-series data 210 based on a Savitzky-Golay filter. Through this, the processor 120 may smooth and correct noise data such as peak data deviating from a trend in the time-series data.

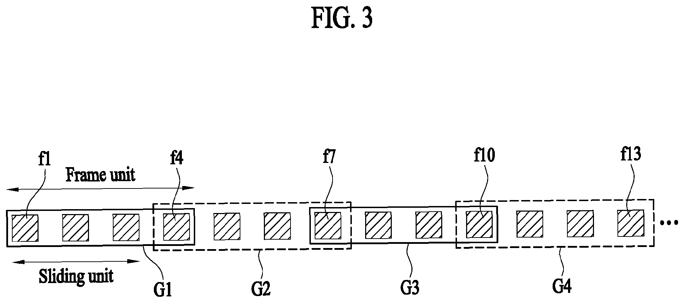

FIG. 3 is a diagram showing an example of calculating first feature data according to an example embodiment disclosed in this document.

Referring to FIG. 3, the processor 120 may calculate the first feature data including a plurality of normalized data from filtering data. In FIG. 3, illustrated is an example of calculating first feature data (G1, G2, G3, G4) from filtering data (f1, f2, ..., fl3) by applying a moving window with a sliding unit of "3" and a frame unit of "4."

For example, when the sliding unit is three blocks and the frame unit is four blocks, the processor 120 may calculate normalized data G1 by grouping f1 to f4 in the filtering data and calculate normalized data G4 by grouping f10 to f13.

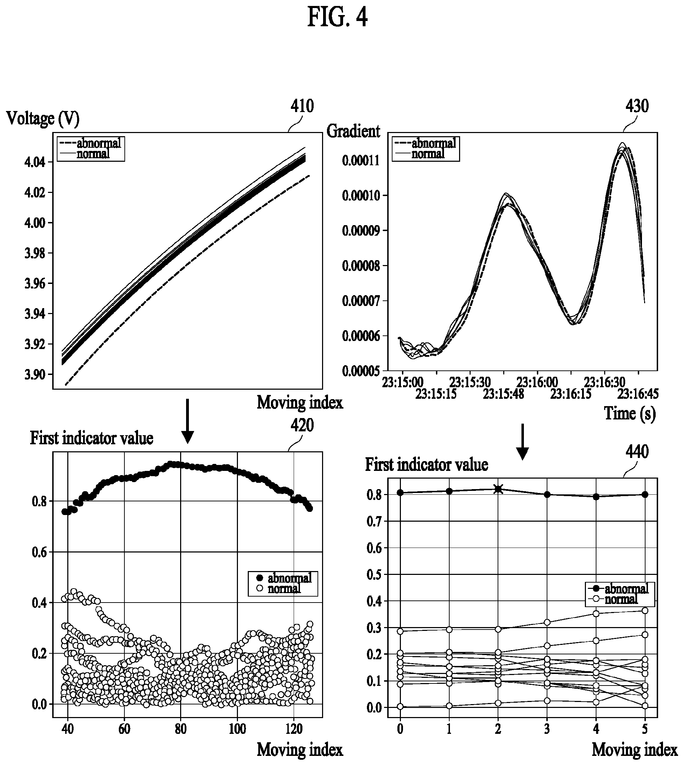

FIG. 4 is a diagram showing an example of calculating a first indicator value according to an example embodiment disclosed in this document.

Referring to FIG. 4, the processor 120 may calculate the first indicator value by inputting first feature data and second feature data into a decomposition model.

In FIG. 4, illustrated are a graph 420 that represents distribution of a first indicator value calculated by inputting first feature data 410 into the decomposition model, and a graph 440 that represents distribution of a first indicator value calculated by inputting second feature data 430 into the decomposition model. In the graph 410, an x-axis of the graph 410 represents a moving index, and a y-axis represents a voltage value (v). In the graph 430, an x-axis represents a time index (s), and a y-axis represents a gradient. In addition, in the graph 420 and the graph 440, an x-axis represents a moving index, and a y-axis represents a first indicator value. Here, the moving index may refer to an order of each of the normalized data in each battery bank.

Referring to the graph 420 and the graph 440 of FIG. 4, an abnormal battery bank has a greater first indicator value compared to a normal battery bank. For example, as illustrated in FIG. 4, the abnormal battery bank has distribution of which a first indicator value is greater than "0.75", and the normal battery bank has distribution of which a first indicator value is less than "0.75". Therefore, the processor 120 may diagnose an abnormality of a battery bank by comparing the first indicator value and a first threshold value (for example, "0.75").

In addition, it is confirmed that the processor 120 may determine a difference between an abnormal battery bank and a normal battery bank more clearly by using the first feature data and the second feature data to calculate the first indicator value.

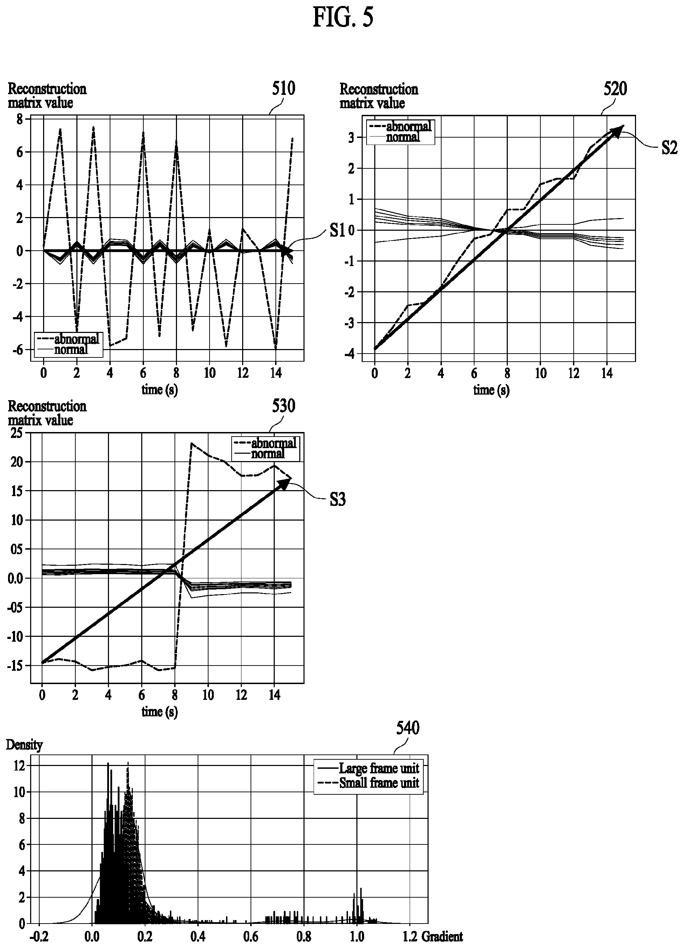

FIG. 5 is a diagram showing an example of determining whether the first indicator value is noise according to an example embodiment disclosed in this document.

A graph 510 to a graph 530 of FIG. 5 illustrate examples of a graph that represents distribution of a reconstruction matrix over time. In the graph 510 to the graph 530, an x-axis represents a time index (s), and a y-axis represents a value of a reconstruction matrix. A graph 540 of FIG. 5 is a diagram that represents distribution of a gradient of a reconstruction signal according to a frame unit.

Referring to the graph 540 of FIG. 5, it is confirmed that distribution of gradients of reconstruction matrices determined as noise and distribution of gradients of valid reconstruction matrices are differentiated. For example, it is confirmed that most of the gradients of the reconstruction matrices determined as noise are distributed within a range of "0.6" or less, and most of the gradients of the valid reconstruction matrices are distributed within a range greater than "0.6".

Therefore, the processor 120 may determine whether the first indicator value is noise according to the gradient of the reconstruction matrix. Referring to the graph 510 to the graph 530 again, the graph 510 illustrates a graph of a reconstruction matrix corresponding to noise, and the graph 520 and the graph 530 each illustrate a graph of a valid reconstruction matrix. In the graph 510, the gradient of the reconstruction matrix converges to zero, and thus the processor 120 may determine it as noise. Conversely, the gradients of the reconstruction matrices of the graph 520 and the graph 530 converge to "1", so that the processor 120 may determine them as valid data.

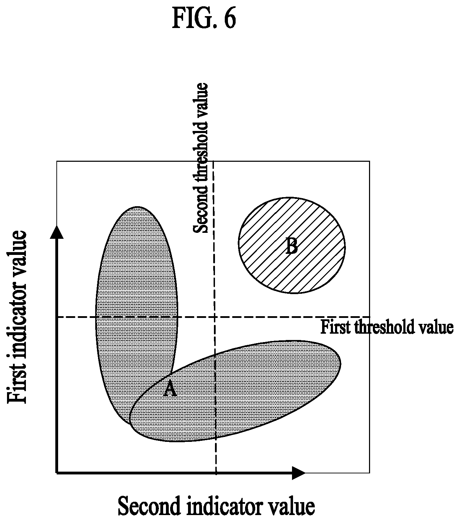

FIG. 6 is a diagram showing an example of diagnosing a battery bank based on a first indicator value and a second indicator value according to an example embodiment disclosed in this document.

Referring to FIG. 6, the processor 120 may diagnose a state of the battery bank by using a result obtained by comparing a first indicator value and a first threshold value and a result obtained by comparing a second indicator value and a second threshold value.

For example, the processor 120 may diagnose a battery bank as an abnormal battery bank when the first indicator value is greater than the first threshold value and when the second indicator value is greater than the second threshold value. Even when the first indicator value is greater than the first threshold value, when the second indicator value that reflects a voltage deviation between battery banks is equal to or less than the second threshold value, this indicates similar voltage behavior of each battery bank, so that the processor 120 may not determine the battery bank as abnormal. In other words, the processor 120 may diagnose the battery bank as normal when the first indicator value and the second indicator value are included in a region A. The processor 120 may determine the battery bank as abnormal when the first indicator value and the second indicator value are included in a region B.

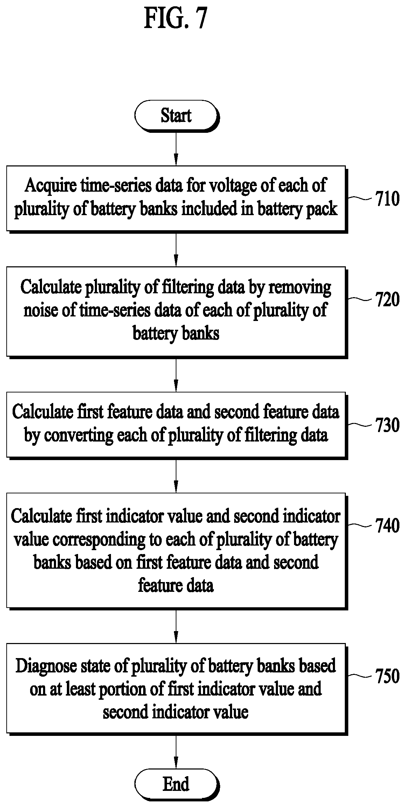

FIG. 7 is a flowchart for describing a diagnosis method of a battery diagnosis device according to an example embodiment disclosed in this document.

In operation 710, the information acquisition interface 110 may acquire time-series data for a voltage of each of a plurality of battery banks included in a battery pack.

In operation 720, the processor 120 may calculate a plurality of filtering data by removing noise of the time-series data of the plurality of battery banks. For example, the processor 120 may calculate the plurality of filtering data by removing the noise of each of the time-series data based on a Savitzky-Golay filter.

In operation 730, the processor 120 may calculate first feature data and second feature data by converting each of the plurality of filtering data. For example, the processor 120 may calculate the first feature data including a plurality of normalized data calculated by grouping each of the filtering data in frame units of a predetermined size while moving each of the filtering data in sliding units. The processor 120 may calculate the second feature data based on a coefficient value calculated by inputting the first feature data into a linear regression model.

In operation 740, the processor 120 may calculate a first indicator value and a second indicator value corresponding to each of the plurality of battery banks based on the first feature data and the second feature data. For example, the processor 120 may calculate the first indicator value based on a transposed matrix factor extracted from a SVD model. The processor 120 may calculate deviations of the plurality of normalized data for the first feature data and calculate an average of the deviations as the second indicator value.

In operation 750, the processor 120 may diagnose a state of the plurality of battery banks based on at least a portion of the first indicator value and the second indicator value. For example, the processor 120 may diagnose a battery bank of which a first indicator value is greater than the first threshold value and of which a second indicator value is greater than the second threshold value as an abnormal battery bank.

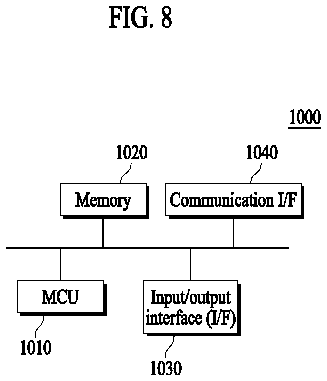

FIG. 8 is a block diagram showing a hardware configuration of a computing system for performing an operation method of a battery diagnosis device according to an example embodiment disclosed in this document.

Referring to FIG. 8, a computing system 1000 according to an example embodiment disclosed in this document may include a microcontroller unit (MCU) 1010, a memory 1020, an input/output interface (I/F) 1030, and a communication I/F 1040.

The MCU 1010 may be a processor that executes various programs stored in the memory 1020 (for example, a time-series data acquisition program, a data filtering program, a feature data calculation program, an indicator value calculation program, and a diagnosis program), processes a variety of pieces of information including a voltage of a battery pack through such programs, and enables functions of the battery diagnosis device illustrated in above-mentioned FIG. 1 to be performed.

The memory 1020 may store the above-mentioned various programs. In addition, the memory 1020 may store a variety of pieces of information including a voltage of a battery pack.

The memory 1020 may be provided as a plurality of memories, if necessary. The memory 1020 may be a volatile memory or a non-volatile memory. As the volatile memory, the memory 1020 may employ a random access memory (RAM), a dynamic random access memory (DRAM), and a static random access memory (SRAM). As the non-volatile memory, the memory 1020 may employ a read-only memory (ROM), a programmable read-only memory (PROM), an electrically alterable read-only memory (EAROM), an erasable programmable read-only memory (EPROM), an electrically erasable programmable read-only memory (EEPROM), and a flash memory. The examples of the memories 1020 described above are merely illustrative and are not intended to limit the scope of the present disclosure.

The input/output I/F 1030 may be provided with an interface that enables data transmission and reception by connecting an input device (not illustrated) such as a keyboard, a mouse, and a touch panel and an output device such as a display (not illustrated).

The communication I/F 1040, as an element that enables transmission and reception of various data with a server, may be implemented as a device capable of supporting wired and/or wireless communication. For example, the battery diagnosis device may transmit and receive a variety of pieces of information including battery voltage information from a separately provided external server through the communication I/F 1040.

As such, by being recorded in the memory 1020 and processed by the MCU 1010, a computer program according to an example embodiment disclosed in this document may be implemented, for example, as a module that performs functions illustrated in FIG. 1.

Meanwhile, disclosed are exemplary embodiments of the present disclosure in the present specification and drawings, it should be understood that specific terms used herein are merely for the purpose of easily describing the technical content of the present disclosure and facilitating understanding of embodiments, and are not intended to limit the scope of the present disclosure. It will be apparent to those skilled in the art that, in addition to the embodiments disclosed herein, various modifications based on the technical spirit of the present disclosure may also be implemented.

A device or terminal according to the above-mentioned embodiments may include a processor, a memory that stores and executes program data, a permanent storage such as a disk drive, a communication port that communicates with an external device, and a user object device such as a touch panel, a key, and a button. Methods implemented as software modules or algorithms may be stored in a computer-readable recording medium as computer-readable codes or program instructions executable by the processor. Here, the computer-readable recording medium may include a magnetic storage medium (for example, a read-only memory (ROM), a random access memory (RAM), a floppy disk, a hard disk) and an optical reading medium (for example, a compact disc read-only memory (CD-ROM), a digital versatile disc (DVD)). The computer-readable recording medium may be distributed across computer systems connected through a network, and computer-readable codes may be stored and executed in a distributed manner. The medium may be readable by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to those components may be executed by software programming or software components, the present example embodiments may be implemented by programming or scripting languages such as C, C++, Java, and assembler language, and Python including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing. The terms "mechanism", "component", "means", and "configuration" may be widely used and are not limited to mechanical and physical elements. These terms may include meaning of a series of routines of software in association with the processor.

**Claims**

1.  A battery diagnosis device comprising:

    an information acquisition interface configured to acquire time-series data for a voltage of each of a plurality of battery banks included in a battery pack; and
    a processor,
    wherein the processor is configured to calculate a plurality of filtering data by removing noise of the time-series data of each of the plurality of battery banks, calculate first feature data and second feature data by converting each of the plurality of filtering data, calculate a first indicator value and a second indicator value corresponding to each of the plurality of battery banks based on the first feature data and the second feature data, and diagnose a state of the plurality of battery banks based on at least a portion of the first indicator value and the second indicator value.

2.  The battery diagnosis device of claim 1, wherein the processor is configured to remove the noise of the time-series data of each of the plurality of battery banks based on a Savitzky-Golay filter.

3.  The battery diagnosis device of claim 1, wherein the processor is configured to calculate the first feature data including a plurality of normalized data calculated by grouping each of the plurality of filtering data in frame units of a predetermined size while moving each of the plurality of filtering data in sliding units.

4.  The battery diagnosis device of claim 3, wherein the processor is configured to calculate the second feature data based on a coefficient value calculated by inputting the first feature data into a linear regression model.

5.  The battery diagnosis device of claim 3, wherein the processor is configured to calculate deviations of each of the plurality of normalized data for the first feature data and calculate an average of the deviations as a second indicator value.

6.  The battery diagnosis device of claim 1, wherein the processor is configured to calculate the first indicator value based on a factor extracted by inputting at least a portion of the first feature data and the second feature data into a decomposition model.

7.  The battery diagnosis device of claim 6, wherein the decomposition model includes a singular value decomposition model, and the processor is configured to calculate the first indicator value based on a transposed matrix factor extracted from the singular value decomposition model.

8.  The battery diagnosis device of claim 6, wherein the processor is configured to calculate a reconstruction matrix based on factors extracted by applying the decomposition model, normalize the reconstruction matrix, and determine whether the first indicator value is noise based on a gradient of the reconstruction matrix calculated by multiplying a coefficient value, which is extracted by inputting the normalized reconstruction matrix into the linear regression model, by a magnitude of the reconstruction matrix.

9.  The battery diagnosis device of claim 1, wherein the processor is configured to diagnose the state of the plurality of battery banks based on whether the first indicator value is greater than a first threshold value and whether the second indicator value is greater than a second threshold value.

10. A battery diagnosis method performed by a battery diagnosis device, the battery diagnosis method comprising:

acquiring time-series data for a voltage of each of a plurality of battery banks included in a battery pack;
calculating a plurality of filtering data by removing noise of the time-series data of each of the plurality of battery banks;
calculating first feature data and second feature data by converting each of the plurality of filtering data;
calculating a first indicator value and a second indicator value corresponding to each of the plurality of battery banks based on the first feature data and the second feature data; and
diagnosing a state of the plurality of battery banks based on at least a portion of the first indicator value and the second indicator value.

# FIG. 1

| | | |
|---|---|---|
| **Battery diagnosis device** | | ~ 10 |
| | | |
| Information acquisition interface | | ~ 110 |
| | | |
| Processor | | ~ 120 |

# FIG. 2

FIG. 3

FIG. 4

# FIG. 5

FIG. 6

# FIG. 7

Start

Acquire time-series data for voltage of each of plurality of battery banks included in battery pack — 710

Calculate plurality of filtering data by removing noise of time-series data of each of plurality of battery banks — 720

Calculate first feature data and second feature data by converting each of plurality of filtering data — 730

Calculate first indicator value and second indicator value corresponding to each of plurality of battery banks based on first feature data and second feature data — 740

Diagnose state of plurality of battery banks based on at least portion of first indicator value and second indicator value — 750

End

# FIG. 8

## INTERNATIONAL SEARCH REPORT

| International application No. |
| --- |
| **PCT/KR2025/005319** |

| A. | CLASSIFICATION OF SUBJECT MATTER |
| --- | --- |

**G01R 31/36**(2006.01)i; **G01R 31/52**(2020.01)i; **G01R 31/396**(2019.01)i; **G01R 19/165**(2006.01)i; **G01R 19/10**(2006.01)i

According to International Patent Classification (IPC) or to both national classification and IPC

| B. | FIELDS SEARCHED |
| --- | --- |

Minimum documentation searched (classification system followed by classification symbols)

G01R 31/36(2006.01); G01R 19/00(2006.01); G01R 31/367(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 노이즈(noise), 필터링(filtering), 사비츠키-골레이(Savitzky-Golay), 시계열 데이터(time series data), 슬라이딩(sliding), 무빙 윈도우(moving window), 선형 회귀(linear regression), 특이값(singular value), 행렬(matrix)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2024-0041264 A (LG ENERGY SOLUTION, LTD.) 29 March 2024 (2024-03-29)<br>See paragraphs [0020], [0039], [0043], [0060], [0069] and [0089]; and claims 1 and 6. | 1-10 |
| Y | KR 10-2022-0100469 A (LG ENERGY SOLUTION, LTD.) 15 July 2022 (2022-07-15)<br>See paragraph [0048]. | 1-10 |
| Y | KR 10-2023-0010545 A (LG ENERGY SOLUTION, LTD.) 19 January 2023 (2023-01-19)<br>See claim 1. | 3-5 |
| Y | KR 10-2022-0016799 A (LG ENERGY SOLUTION, LTD.) 10 February 2022 (2022-02-10)<br>See paragraphs [0064] and [0098]. | 6-8 |
| A | KR 10-2023-0166047 A (LG ENERGY SOLUTION, LTD.) 06 December 2023 (2023-12-06)<br>See abstract. | 1-10 |

☐ Further documents are listed in the continuation of Box C.    ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **15 July 2025** | **15 July 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
| --- |
| **PCT/KR2025/005319** |

| Patent document cited in search report | | | Publication date (day/month/year) | Patent family member(s) | | | Publication date (day/month/year) |
| --- | --- | --- | --- | --- | --- | --- | --- |
| KR | 10-2024-0041264 | A | 29 March 2024 | EP | 4571333 | A1 | 18 June 2025 |
| | | | | KR | 10-2024-0041208 | A | 29 March 2024 |
| | | | | KR | 10-2024-0119025 | A | 06 August 2024 |
| | | | | KR | 10-2690387 | B1 | 05 August 2024 |
| | | | | WO | 2024-063600 | A1 | 28 March 2024 |
| KR | 10-2022-0100469 | A | 15 July 2022 | CN | 116507930 | A | 28 July 2023 |
| | | | | EP | 4231026 | A1 | 23 August 2023 |
| | | | | EP | 4231026 | A4 | 22 May 2024 |
| | | | | JP | 2024-501510 | A | 12 January 2024 |
| | | | | US | 2024-0006670 | A1 | 04 January 2024 |
| | | | | WO | 2022-149822 | A1 | 14 July 2022 |
| KR | 10-2023-0010545 | A | 19 January 2023 | CN | 116324449 | A | 23 June 2023 |
| | | | | EP | 4206713 | A1 | 05 July 2023 |
| | | | | EP | 4206713 | A4 | 03 April 2024 |
| | | | | JP | 2023-538347 | A | 07 September 2023 |
| | | | | JP | 2024-137945 | A | 07 October 2024 |
| | | | | JP | 7498358 | B2 | 11 June 2024 |
| | | | | US | 2023-0366935 | A1 | 16 November 2023 |
| | | | | WO | 2023-287180 | A1 | 19 January 2023 |
| KR | 10-2022-0016799 | A | 10 February 2022 | CN | 115769091 | A | 07 March 2023 |
| | | | | EP | 4166963 | A1 | 19 April 2023 |
| | | | | EP | 4166963 | A4 | 29 November 2023 |
| | | | | EP | 4166963 | B1 | 30 October 2024 |
| | | | | ES | 2998808 | T3 | 21 February 2025 |
| | | | | HU | E068903 | T2 | 28 February 2025 |
| | | | | JP | 2023-527806 | A | 30 June 2023 |
| | | | | JP | 7389278 | B2 | 29 November 2023 |
| | | | | PL | 4166963 | T3 | 07 January 2025 |
| | | | | US | 2023-0184837 | A1 | 15 June 2023 |
| | | | | WO | 2022-030971 | A1 | 10 February 2022 |
| KR | 10-2023-0166047 | A | 06 December 2023 | CN | 118043690 | A | 14 May 2024 |
| | | | | EP | 4394404 | A1 | 03 July 2024 |
| | | | | EP | 4394404 | A4 | 12 March 2025 |
| | | | | EP | 4553508 | A2 | 14 May 2025 |
| | | | | JP | 2025-507568 | A | 21 March 2025 |
| | | | | KR | 10-2024-0019187 | A | 14 February 2024 |
| | | | | KR | 10-2025-0094650 | A | 25 June 2025 |
| | | | | KR | 10-2632629 | B1 | 02 February 2024 |
| | | | | KR | 10-2824599 | B1 | 25 June 2025 |
| | | | | US | 12085626 | B2 | 10 September 2024 |
| | | | | US | 2023-0384393 | A1 | 30 November 2023 |
| | | | | US | 2024-0027540 | A1 | 25 January 2024 |
| | | | | US | 2024-0393406 | A1 | 28 November 2024 |
| | | | | WO | 2023-229326 | A1 | 30 November 2023 |

Form PCT/ISA/210 (patent family annex) (July 2022)

**REFERENCES CITED IN THE DESCRIPTION**

**Patent documents cited in the description**

- KR 20240060784
- KR 20240075926